(19) **Europäisches Patentamt European Patent Office Office européen des brevets**

(11) **EP 4 045 922 B1**

(12) ## EUROPÄISCHE PATENTSCHRIFT

(45) Veröffentlichungstag und Bekanntmachung des Hinweises auf die Patenterteilung:
**06.12.2023 Patentblatt 2023/49**

(21) Anmeldenummer: **20793334.2**

(22) Anmeldetag: **15.10.2020**

(51) Internationale Patentklassifikation (IPC):
**G01R 27/16** *(2006.01)* **G01R 27/18** *(2006.01)*
**G01R 31/52** *(2020.01)* **H02H 3/16** *(2006.01)*

(52) Gemeinsame Patentklassifikation (CPC):
**G01R 27/18; H02H 3/162**

(86) Internationale Anmeldenummer:
**PCT/EP2020/079116**

(87) Internationale Veröffentlichungsnummer:
**WO 2021/074333 (22.04.2021 Gazette 2021/16)**

(54) **VERFAHREN UND VORRICHTUNG ZUM BESTIMMEN DES RESISTIVEN ANTEILS DER ABLEITSTROMIMPEDANZ IM WECHSELSTROMNETZ**

METHOD AND DEVICE FOR DETERMINING THE RESISTIVE COMPONENT OF THE LEAKAGE CURRENT IMPEDANCE IN THE ALTERNATING CURRENT NETWORK

PROCÉDÉ ET DISPOSITIF POUR DÉTERMINER LA COMPOSANTE RÉSISTIVE DE L'IMPÉDANCE DE COURANT DE FUITE DANS UN RÉSEAU À COURANT ALTERNATIF

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.10.2019 DE 102019007224**

(43) Veröffentlichungstag der Anmeldung:
**24.08.2022 Patentblatt 2022/34**

(73) Patentinhaber: **Safetytest GmbH**
**96114 Hirschaid Bayern (DE)**

(72) Erfinder:
• **SCHULZE, Simon**
**90425 Nürnberg (DE)**
• **SCHULZE, Wolfgang**
**90425 Nürnberg (DE)**
• **VERGOV, Dimitar**
**90425 Nürnberg (DE)**

(74) Vertreter: **Zeitler Volpert Kandlbinder Patentanwälte Partnerschaft mbB Werner-Eckert-Str. 4 81829 München (DE)**

(56) Entgegenhaltungen:
EP-A1- 3 136 115    EP-A2- 2 571 128
DE-A1- 10 355 086    DE-A1- 19 826 410
DE-A1-102015 218 911    US-A1- 2003 112 015

EP 4 045 922 B1

**Beschreibung**

Die Erfindung bezieht sich auf ein Verfahren und auf eine Vorrichtung zum Bestimmen des resistiven Anteils der Ableitstromimpedanz im Wechselstromnetz.

Zur Vorbeugung von Personenschäden durch Elektrounfälle ist es erforderlich eine Überprüfung von elektrischen Geräten und Anlagen hinsichtlich des Isolationswiderstands und des Fehlerstroms durchzuführen. Dabei ist die Bewertung des Isolationswiderstandes $R_{iso}$ zwischen den aktiven Leitern (Phase L und Neutralleiter N) und dem Schutzleiter PE in einem Wechselstromnetz und/oder einem daran angeschlossenen Verbraucher ein wichtiges Qualitäts- und Sicherheitsmerkmal. Die Überprüfung des Isolationswiderstandes $R_{iso}$ ist in vielen Normen vorgeschrieben. Grenzwerte für den Isolationswiderstand $R_{iso}$ sind gewöhnlich größer als 1 MOhm.

Der Isolationswiderstand $R_{iso}$ kann jedoch direkt nur ohne Netzspannung gemessen werden. Dadurch kann die Isolation von Teilen, die hinter allpolig trennenden Schaltern oder Schützen liegen, nicht erfasst werden. Als Alternative zum direkten Messen des Isolationswiderstand $R_{iso}$ wird im Betrieb die Differenzstrommessmethode verwendet, welche den Differenzstrom zwischen der Phase L und dem Neutralleiter N ermittelt. Dieser Differenzstrom entspricht im Wesentlichen dem Ableitstrom zwischen den aktiven Leitern (Phase L und Neutralleiter N) und dem Schutzleiter PE bei eingeschaltetem Wechselstromnetz. Durch systembedingte, gewöhnlich aus EMV-Gründen eingebaute kapazitive Filterelemente in dem Wechselstromnetz und/oder dem Verbraucher, sind die Grenzwerte in den Normen für den maximal zulässigen Differenzstrom relativ hoch z.B. 3,5 mA, was einer Wechselstromimpedanz bei einem Netz von 230 V von nur 66 kOhm entspricht. Ein hoher Differenzstrom führt zu einer hohen Gefährdung. Bei 3,5 mA ist man weit von einer hohen Impedanz entfernt. Hieraus ist ersichtlich, dass Isolationswiderstände $R_{iso}$, die ein Indikator für Verschmutzung oder Alterung eines Verbrauchers sind, von größer 1 MOhm nicht erfasst werden können. Dadurch ist die Prüfschärfe bei der Bestimmung des Isolationswiderstands $R_{iso}$ über die Bestimmung des reinen Differenzstromes eingeschränkt.

Die DE 198 26 410 A1 beschreibt ein Verfahren und eine Einrichtung zur Isolations-und Fehlerstromüberwachung in einem Wechselstromnetz. Dabei wird der Differenzstrom zwischen zumindest zwei Netzleitern erfasst. Der Wechselstromanteil des Differenzstroms wird als eine erste Netzgröße erfasst und die Netzwechselspannung zwischen zumindest zwei Netzleitern oder zwischen einem Netzleiter und einem Schutzleiter oder einem Neutralleiter wird als eine zweite Netzgröße erfasst. Das Produkt zwischen der Amplitude des Wechselstromanteils des Differenzstroms und dem Kosinus des Phasenwinkels φ zwischen den beiden erfasste Netzgrößen ist ein Maß für den resistiven Fehlerstrom. Die Lastabschaltung wird dann durchgeführt, wenn das ermittelte Produkt einen bestimmten Ansprechwert übersteigt. Die in der DE 198 26 410 A1 vorgeschlagene Bestimmung für den resistiven Fehlerstrom gilt jedoch nur für sinusförmige Spannungen und Ströme.

Die US 6,922,643 B2 zeigt ebenfalls ein Verfahren und eine Vorrichtung zum Bestimmen eines Fehlerstroms in einem Wechselstromnetz.

Die DE 103 55 086 A1 beschreibt ein Verfahren zum Bestimmen des ohmschen Isolationswiderstands eines geerdeten, ein- oder mehrphasigen, betriebsbereiten und arbeitenden Wechselstromnetzes, bei dem insbesondere der Differenzstrom gemessen und ausgewertet wird.

Die EP 3 136 115 A1 offenbart eine Vorrichtung und ein Verfahren zum Bestimmen des resistiven Anteils der Ableitstromimpedanz. Dazu werden die Spannung zwischen Phase und Neutralleiter, der Differenzstrom, die Wirkleistung und die Effektivspannung bestimmt. Auf die Phasenkorrektur zwischen Spannung und Differenzstrom wird nicht eingegangen.

Die EP 2 571 128 A2 beschreibt eine elektrische Überwachungseinrichtung und ein Verfahren zur Sicherstellung der Schutzfunktion einer Fehlerstrom-Schutzeinrichtung. Die Überwachungseinrichtung ist in Reihe zu der Fehlerstrom-Schutzeinrichtung geschalten. Der Differenzstrom wird von Messstromwandlerkreisen der Überwachungseinrichtung erfasst und von einer Auswerteeinheit der Überwachungseinrichtung bewertet. Wird ein funktionsgefährdender Fehlerstrom erkannt, dann erzeugt die Auswerteeinheit ein Abschaltsignal.

Die US 2003/0112015 A1 offenbart eine Vorrichtung und ein Verfahren zum Bestimmen des resistiven Anteils der Ableitstromimpedanz. Dabei werden eine Spannung und ein Differenzstrom gemessen. Bei der Spannung und bei dem Differenzstrom wird jeweils eine Fourieranalyse durchgeführt. Über die dritte Oberschwingung wird die Phase zwischen Spannung und Differenzstrom, die Wirkleistung und schließlich der resistive Anteil der Ableitstromimpedanz berechnet.

Die DE 10 2015 218 911 A1 beschreibt einen Fehlerstromschutzschalter für einen elektrischen Stromkreis. Bei Überschreitung eines ersten Differenzstromgrenzwertes wird der elektrische Stromkreis durch eine Auslöseeinheit unterbrochen.

Der Erfindung liegt die Aufgabe zugrunde, ein Verfahren bereitzustellen, bei welchem die Isolations- und Fehlerstromüberwachung verbessert werden kann. Ebenso ist es eine Aufgabe der Erfindung, eine Vorrichtung bereitzustellen, bei welcher die Isolations- und Fehlerstromüberwachung verbessert werden kann.

Diese Aufgabe wird durch den Gegenstand des unabhängigen Patentanspruchs 1 gelöst. Vorteilhafte Ausgestaltungen des erfindungsgemäßen Verfahrens sind Gegenstand von abhängigen Patentansprüchen und ergeben sich aus der nachfolgenden Beschreibung der Erfindung. Eine erfindungsgemäße Vorrichtung wird in Anspruch 9 beschrieben.

Demgemäß wird ein Verfahren zum Bestimmen des resistiven Anteils der Ableitstromimpedanz eines nachgeschalteten Zweigs an ein Wechselstromnetz mit einer Phase, einem Neutralleiter und einem Schutzleiter beschrieben. Das Verfahren weist die folgenden Schritte auf:

- Abtastendes Messen eines Differenzstroms $I_{LN}$ zwischen der Phase und dem Neutralleiter mittels eines Differenzstromsensors,
- Abtastendes Messen einer Spannung U zwischen der Phase und dem Neutralleiter oder zwischen der Phase und dem Schutzleiter,
- Korrigieren einer Phasenverschiebung zwischen dem Differenzstrom $I_{LN}$ und der Spannung U,
- Bestimmen mehrerer einzelner Differenzstromwerte $I_{LN,i}$ und mehrerer einzelner Spannungswerte $U_i$, wobei die Differenzstromwerte $I_{LN,i}$ zu den Spannungswerten $U_i$ phasenkorrigiert sind,
- Bestimmen der Wirkleistung P aus den mehreren einzelnen Differenzstromwerten $I_{LN,I}$ und den mehreren einzelnen Spannungswerten $U_i$,
- Bestimmen der Effektivspannung $U_{Eff}$ mittels der Spannungswerte $U_i$, und
- Bestimmen des resistiven Anteils der Ableitstromimpedanz mittels der Effektivspannung $U_{Eff}$ und der Wirkleistung P.

Dadurch, dass der Differenzstroms $I_{LN}$ und die Spannung U abtastend gemessen werden, ergibt sich auch eine digitale Erfassung der Wirkleistung der Ableitstromimpedanzen. Dadurch kann der resistive Anteil der Ableitstromimpedanz auch bei nicht sinusförmigen Netzspannungen und nicht sinusförmigen Strömen bestimmt werden.

Dabei werden beim abtastenden Messen des Differenzstroms $I_{LN}$ einzelne Differenzstromabtastwerte mit einem vorbestimmten zeitlichen Abstand zueinander gemessen und beim abtastenden Messen der Spannung U einzelne Spannungsabtastwerte mit einem vorbestimmten zeitlichen Abstand zueinander gemessen.

Die Spannung U wird abtastend zwischen der Phase und dem Neutralleiter gemessen, d.h. es wird eine Spannung $U_{LN}$ gemessen. Alternativ wird die Spannung U abtastend zwischen der Phase und dem Schutzleiter gemessen, d.h. es wird eine Spannung $U_{LPE}$ gemessen.

Die Korrektur der Phasenverschiebung erfolgt vorzugsweise digital.

Gemäß einer Ausführungsform des Verfahrens ist das Wechselstromnetz ein TN-Wechselstromnetz. Alternativ könnte das Wechselstromnetz auch ein TT-Wechselstromnetz oder ein IT-Wechselstromnetz sein.

Gemäß einer weiteren Ausführungsform des Verfahrens wird zum Justieren einer Vorrichtung zum Bestimmen des resistiven Anteils der Ableitstromimpedanz zuerst ein Wert für das Korrigieren der Phasenverschiebung ermittelt, indem an das Wechselstromnetz ein nachgeschalteter Zweig mit einer rein kapazitiven Last, einer rein induktiven Last oder einer rein resistiven Last angeschlossen wird. Anschließend wird eine Spannung U und ein Differenzstrom $I_{LN}$ mit diesem nachgeschalteten Zweig ermittelt. Vorteilhafterweise kann mit einem solchen nachgeschalteter Zweig mit einer rein kapazitiven Last, einer rein induktiven Last oder einer rein resistiven Last ein Wert für die Phasenverschiebung ermittelt werden, welcher in einer späteren Messung an dem dann zu vermessenden nachgeschalteten Zweig zur Korrektur verwendet werden kann.

Gemäß einer weiteren Ausführungsform des Verfahrens werden bei dem abtastenden Messen eines Differenzstroms $I_{LN}$ einzelne Differenzstromabtastwerte gemessen. Bei dem abtastenden Messen einer Spannung U werden einzelne Spannungsabtastwerte gemessen. Weiter wird ein zeitlicher Differenzstromverlauf aus einer Interpolation der Differenzstromabtastwerte gewonnen und ein zeitlicher Spannungsverlauf wird aus einer Interpolation der Spannungsabtastwerte gewonnen, um die Korrektur der Phasenverschiebung zwischen dem Differenzstrom $I_{LN}$ und der Spannung U zu verbessern. Vorteilhafterweise kann mittels der Interpolation der Differenzstromabtastwerte und der Interpolation der Spannungsabtastwerte die Phasenverschiebung genau bestimmt werden.

Gemäß einer weiteren Ausführungsform des Verfahrens weist bei dem abtastenden Messen des Differenzstroms $I_{LN}$ der Differenzstromsensor einen Kompensationsleiter auf. Dabei wird mittels des Kompensationsleiters ein Fehler des Differenzstromsensors ausgeglichen. Dazu werden der Kompensationsleiter, die Phase und der Neutralleiter durch einen Kern des Kompensationsleiters geführt. Mittels des Kompensationsleiters kann ausgeglichen werden, dass die Phase und der Neutralleiter nicht genau symmetrisch durch den Kern geführt werden. Der Kompensationsleiter kompensiert demnach die Asymmetrie der Einheit bestehend aus Kern, Phase und Neutralleiter. Dazu wird ein Kompensationsstrom, welcher proportional zu dem durch die Phase fließenden Strom sein kann, durch den Kompensationsleiter geschickt.

Gemäß einer weiteren Ausführungsform des Verfahrens ist der durch den Kompensationsleiter fließende Strom proportional zu dem Strom, welcher durch die Phase oder den Neutralleiter fließt. Demzufolge kann die Kompensationsschaltung, welche den Stromfluss durch den Kompensationsleiter verursacht, einfach aufgebaut sein. Der Strom, welcher durch die Phase oder den Neutralleiter fließt, wird dann lediglich mit einem konstanten Faktor versehen.

Gemäß einer weiteren Ausführungsform des Verfahrens wird ein Fehler des Differenzstromsensors ausgeglichen, indem aus der Messgröße Strom der Phase und/oder aus der Messgröße Strom des Neutralleiters ein Faktor Kp berechnet wird, und zu jedem gemessenen Differenzstromwert $I_{LN,i}$ ein Wert $Kp*I_{LN,i}$ abgezogen wird. Demzufolge erfolgt die Kompensation des Fehlers des Differenzstromsensors digital. Bevorzugt wird entweder die Messgröße Strom der Phase oder die Messgröße Strom des Neutralleiters und der Differenzstrom $I_{LN}$ erfasst. Mittels des Stroms der Phase (oder des Stroms des Neutralleiters) wird dann der Differenzstrom $I_{LN}$ digital korrigiert. Aus der Messgröße Strom der Phase (oder der Messgröße Strom des Neutralleiters) wird ein Faktor Kp berechnet. Zu jedem gemessenen Differenzstromwert $I_{LN,i}$ wird dann ein Wert $Kp*I_{LN,i}$ abgezogen.

Gemäß einer weiteren Ausführungsform des Verfahrens wird das Wechselstromnetz abgeschaltet und/oder eine Meldung an ein übergeordnetes System gesendet, wenn der resistive Anteil der Ableitstromimpedanz einen vorbestimmten Wert unterschreitet. Je niedriger der resistive Anteil der Ableitstromimpedanz ist, desto höher kann der Ableitstrom sein. Da ein hoher Ableitstrom gefährlich sein kann, ist ein zu niedriger resistiver Anteil der Ableitstromimpedanz nicht gewünscht. Daher kann das Wechselstromnetz bei einem zu niedrigen resistiven Anteil der Ableitstromimpedanz abgeschaltet werden. Dabei kann "abgeschaltet" bedeuten, dass das Wechselstromnetz ausgeschaltet wird oder dass das Wechselstromnetz von dem nachgeschalteten Zweig allpolig getrennt wird.

Unter dem übergeordneten System ist beispielsweise ein Cloudsystem oder ein Monitorsystem zu verstehen. Das Cloudsystem ist ein System, welches über das Internet erreichbar ist. Das Monitorsystem ist ein lokales System, welches zur Überwachung von einzelnen Parametern geeignet ist.

Alternativ oder zusätzlich zu dem resistiven Anteil der Ableitstromimpedanz kann auch ein weiterer Netzparameter überwacht werden. Aufgrund einer Überschreitung oder Unterschreitung des erfassten weiteren Netzparameters kann eine Meldung an das übergeordnete System erfolgen und/oder eine Abschaltung des Wechselstromnetzes erfolgen. Bei dem weiteren Netzparameter kann es sich beispielsweise um den Differenzstrom $I_{LN}$ handeln.

Weiter wird eine Vorrichtung angepasst zum Bestimmen des resistiven Anteils der Ableitstromimpedanz eines nachgeschalteten Zweigs an ein Wechselstromnetz mit einer Phase, einem Neutralleiter und einem Schutzleiter bereitgestellt. Dabei weist die Vorrichtung folgende Komponenten auf: einen Spannungssensor angepasst zum abtastenden Messen der Spannung U zwischen der Phase und dem Neutralleiter oder zwischen der Phase und dem Schutzleiter, einen Differenzstromsensor angepasst zum abtastenden Messen eines Differenzstroms $I_{LN}$ zwischen der Phase und dem Neutralleiter, und eine Auswerteeinheit angepasst zum Korrigieren einer Phasenverschiebung zwischen dem Differenzstrom $I_{LN}$ und der Spannung U, angepasst zum Bestimmen mehrerer einzelner Differenzstromwerte $I_{LN,i}$ und mehrerer einzelner Spannungswerte $U_i$, wobei die Differenzstromwerte $I_{LN,i}$ zu den Spannungswerte $U_i$ phasenkorrigiert sind, angepasst zum Bestimmen der Wirkleistung P aus den mehreren einzelnen Differenzstromwerten $I_{LN,i}$ und den mehreren einzelnen Spannungswerten $U_i$, angepasst zum Bestimmen der Effektivspannung $U_{Eff}$ mittels der Spannungswerte $U_i$, und angepasst zum Bestimmen des resistiven Anteils der Ableitstromimpedanz mittels der Effektivspannung $U_{Eff}$ und der Wirkleistung P.

Vorteilhafterweise ist die beschriebene Vorrichtung dazu geeignet, dass beschriebene Verfahren auszuführen.

Gemäß einer Ausführungsform der Vorrichtung weist der Differenzstromsensor einen Kern und einen Kompensationsleiter auf. Dabei sind die Phase, der Neutralleiter und der Kompensationsleiter durch den Kern hindurchgeführt. Aufgrund der nichtsymmetrischen Anordnung von Phase und Neutralleiter in Bezug auf den Kern kann es zu einem Symmetriefehler bei der Differenzstrommessung kommen. Mittels des Kompensationsleiters kann dieser Symmetriefehler ausgeglichen werden. Der Kompensationsleiter kompensiert demnach die Asymmetrie der Einheit bestehend aus Kern, Phase und Neutralleiter. Dazu wird ein Kompensationsstrom, welcher proportional zu dem durch die Phase fließenden Strom sein kann, durch den Kompensationsleiter geschickt.

Alternativ kann die Kompensation des Fehlers des Differenzstromsensors auch digital erfolgen. Ein Kompensationsleiter ist in diesem Fall nicht erforderlich.

Gemäß einer weiteren Ausführungsform der Vorrichtung weist die Vorrichtung ein Monitorsystem auf, welches mit der Auswerteeinheit verbunden ist, um den resistiven Anteil der Ableitstromimpedanz zu überwachen. Dabei kann das Monitorsystem den resistiven Anteil der Ableitstromimpedanz anzeigen, so dass ein Benutzer eine Entscheidung treffen kann, ob das Wechselstromnetz abgeschaltet werden soll. Alternativ oder zusätzlich kann das Monitorsystem den resistiven Anteil der Ableitstromimpedanz auch elektronisch überprüfen und selbständig eine Entscheidung treffen, ob das Wechselstromnetz abgeschaltet wird.

Außerdem kann die Vorrichtung alternativ oder zusätzlich die Messdaten zur Analyse und Verarbeitung an ein Cloudsystem weiterleiten.

Weiter wird ein Verteilerschrank mit zumindest einer Vorrichtung, wie zuvor beschrieben, bereitgestellt. Dabei kann eine oder mehrere Vorrichtungen sehr einfach in den Verteilerschrank eingebaut, eingeklemmt bzw. eingesteckt werden.

Die zumindest eine Vorrichtung erfasst die Netzparameter Differenzstrom $I_{LN}$, Spannung U und Isolationswiderstand, d.h. den resistiven Anteil der Ableitstromimpedanz $R_{iso}$. Dabei können von dem Verteilerschrank weitere Netzparameter erfasst werden. Solche Netzparameter sind beispielsweise die Wirkleistung eines Verbrauchers und der Strom eines Verbrauchers. Weiter kann der Verteilerschrank einen Energiezähler aufweisen. Zudem kann eine Strommessung des Neutralleiters durch eine Oberwellenanalyse und Energieanalyse Aufschluss über Störlichtbogen geben.

Gemäß einer Ausführungsform des Verteilerschranks ist die zumindest eine Vorrichtung als Reihenklemme ausgebildet. Dabei kann die Reihenklemme eine flach gehaltene Klemme sein. Mehrere Reihenklemmen können in größerer Zahl auf einer Tragschiene aneinandergereiht werden. Dazu kann der Verteilerschrank eine Tragschiene aufweisen. Die Reihenklemme kann unter anderem zum lösbaren Anschluss oder der Verbindung von Drähten, Adern und Leitungen in dem Verteilerschrank dienen.

Gemäß einer weiteren Ausführungsform des Verteilerschranks weist der Verteilerschrank zumindest eine weitere Vorrichtung auf. Dabei werden Messwerte der zumindest einen Vorrichtung mit der zumindest einen weiteren Vorrichtung ausgetauscht. Vorteilhafterweise ist der Verteilerschrank dazu geeignet, dass Messwerte zwischen den Vorrichtungen austauschbar sind. Vorteilhafterweise müssen dann nicht in jeder Vorrichtung die gleichen Messungen erneut vorgenommen werden.

Die für das vorgeschlagene Verfahren beschriebenen Ausführungsformen und Merkmale gelten für die vorgeschlagene Vorrichtung und den vorgeschlagenen Verteilerschrank entsprechend und umgekehrt.

Weitere mögliche Implementierungen der Erfindung umfassen auch nicht explizit genannte Kombinationen von zuvor oder im Folgenden beschriebenen Merkmalen. Dabei können auch Einzelaspekte als Verbesserungen oder Ergänzungen zu der jeweiligen Grundform der Erfindung hinzugefügt werden.

Die Erfindung wird im Folgenden anhand der Zeichnungen näher erläutert. Diese zeigen in

Fig. 1 eine schematische Ansicht einer Vorrichtung zum Bestimmen des resistiven Anteils der Ableitstromimpedanz eines nachgeschalteten Zweigs an ein TN-Wechselstromnetz,

Fig. 2 ein Ablaufdiagramm eines Verfahrens zum Bestimmen des resistiven Anteils der Ableitstromimpedanz eines nachgeschalteten Zweigs an ein TN-Wechselstromnetz,

Fig. 3 eine schematische Ansicht des in Fig. 1 dargestellten Differenzstromsensors,

Fig. 4 ein Blockschaltbild des in Fig. 3 dargestellten Differenzstromsensors,

Fig. 5 einen Schaltplan zur Ansteuerung des Kompensationsleiters des in Fig. 3 dargestellten Differenzstromsensors.

In den Figuren sind gleiche oder funktionsgleiche Elemente mit denselben Bezugszeichen versehen worden. Ferner sollte beachtet werden, dass die Darstellungen in den Figuren nicht notwendigerweise maßstabsgerecht sind.

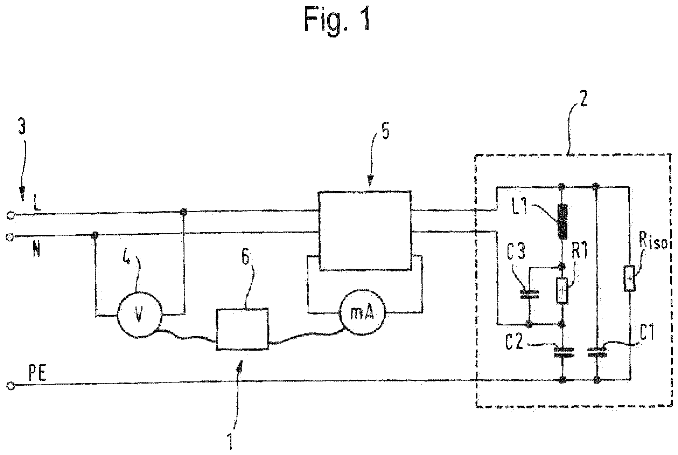

Fig. 1 zeigt eine schematische Ansicht einer Vorrichtung 1 zum Bestimmen des resistiven Anteils der Ableitstromimpedanz $R_{iso}$ eines nachgeschalteten Zweigs 2 an ein TN-Wechselstromnetz 3. Das TN-Wechselstromnetz 3 wist eine Phase L, einen Neutralleiter N und einen Schutzleiter PE auf.

Die Vorrichtung 1 umfasst einen Spannungssensor 4, einen Differenzstromsensor 5 und eine Auswerteeinheit 6. Der Spannungssensor 4 misst die Spannung $U_{LN}$ zwischen der Phase L und dem Neutralleiter N. Alternativ könnte der Spannungssensor 4 auch eine Spannung $U_{LPE}$ zwischen der Phase L und dem Schutzleiter PE messen.

Die aktiven Leiter Phase L und Neutralleiter N werden durch den Differenzstromsensor 5 geführt. Der Differenzstromsensor 5 summiert die Ströme der Phase L und des Neutralleiters N. Wenn kein Ableitstrom fließt, ist die Summe null. Wenn ein Ableitstrom vorhanden ist, fließt ein Teil des Stroms nicht durch den Neutralleiter N zurück. Demnach wird ein Differenzstrom $I_{LN}$ zwischen der Phase L und dem Neutralleiter N gemessen.

Die Auswerteeinheit 6 dient zum Korrigieren der Phasenverschiebung zwischen dem Differenzstrom $I_{LN}$ und der Spannung $U_{LN}$, zum Bestimmen mehrerer einzelner Differenzstromwerte $I_{LN,i}$ und mehrerer einzelner Spannungswerte $U_{LN,i}$, wobei die Differenzstromwerte $I_{LN,i}$ zu den Spannungswerte $U_{LN,i}$ phasenkorrigiert sind, zum Bestimmen der Wirkleistung P aus den mehreren einzelnen Differenzstromwerten $I_{LN,i}$ und den mehreren einzelnen Spannungswerten $U_{LN,i}$, zum Bestimmen der Effektivspannung $U_{Eff}$ mittels der Spannungswerte $U_{LN,i}$, und zum Bestimmen des resistiven Anteils der Ableitstromimpedanz $R_{iso}$ mittels der Effektivspannung $U_{Eff}$ und der Wirkleistung P.

Ist der resistive Anteil der Ableitstromimpedanz $R_{iso}$ kleiner als ein Grenzwert, beispielsweise 1 MOhm, dann kann der nachgeschaltete Zweig 2 mittels eines Schalters (in Fig. 1 nicht gezeigt) allpolig von dem TN-Wechselstromnetz 3 getrennt werden.

Der nachgeschaltete Zweig 2 weist einen ersten Zweig mit dem Widerstand $R_{iso}$ auf. Dieser erste Zweig ergibt einen rein resistiven Ableitstrom. Weiter weist der nachgeschaltete Zweig 2 einen zweiten Zweig mit einer Kapazität C1 auf. Dieser zweite Zweig ergibt einen rein kapazitiven Ableitstrom. Der nachgeschaltete Zweig 2 weist noch einen dritten Zweig mit einer Induktivität L1, einem Widerstand R1, einer Kapazität C3 und einer Kapazität C2 auf. Dieser dritte Zweig ergibt einen Ableitstrom indem der Widerstand R1 einen resistiven Anteil erzeugt. Dieser Strom würde jedoch bei einer DC-Isolationswiderstandsmessung nicht erfasst werden, da er über die Kapazität C2 bei einer DC-Messmethode abgekoppelt ist. Dieses Beispiel zeigt, dass die AC-Messmethode resistive Werte angeben kann, welche aber keinen geringeren Isolationswiderstandswert bei DC-Messmethoden erzeugen würde.

Durch Erfassen des resistiven Anteils der Ableitstromimpedanz $R_{iso}$ des nachgeschalteten Zweigs 2 an das TN-Wechselstromnetz 3 ist es möglich, die Isolation des nachgeschalteten Zweigs 2 im Betriebszustand zu bewerten. Eine Verfälschung der Messergebnisse ergibt sich durch resistive Anteile, die in Reihe zu kapazitiven Anteilen vorhanden sind. Diese werden mit gemessen, in der Isolationswiderstandsbestimmung jedoch nicht berücksichtigt. Resistive Anteile (siehe Widerstand R1), in Reihe zu Kapazitäten (siehe Kapazität C2), die das Ergebnis eines typischen Isolationswiderstandsgrenzwertes von 1 MOhm signifikant beeinflussen, sind jedoch unüblich.

Die Vorrichtung 1 kann ein Monitorsystem (in Figur 1 nicht gezeigt) aufweisen , welches mit der Auswerteeinheit 6 verbunden ist. Mittels des Monitorsystems kann der resistive Anteil der Ableitstromimpedanz $R_{iso}$ überwacht werden. D.h. Mittels des Monitorsystems ist eine manuelle und/oder maschinelle Überwachung des resistiven Anteils der Ableitstromimpedanz $R_{iso}$ möglich.

Weiter kann ein Verteilerschrank mehrere Vorrichtungen 1 aufweisen. Dabei können die Vorrichtungen 1 insbesondere als Reihenklemmen ausgebildet sein. Zudem kann man eine einzelne Vorrichtung so ausbilden, dass sie einzelne Messwerte mit einer anderen Vorrichtung 1 austauscht, d.h. ein Messwert von einer Vorrichtung 1 wird zu einer anderen Vorrichtung 1 übertragen.

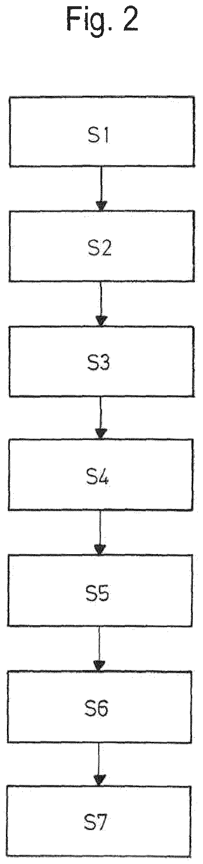

Fig. 2 zeigt ein Ablaufdiagramm eines Verfahrens zum Bestimmen des resistiven Anteils der Ableitstromimpedanz $R_{iso}$ eines nachgeschalteten Zweigs 2 an ein TN-Wechselstromnetz 3.

In einem ersten optionalen Schritt S1 wird ein nachgeschalteter Zweig mit einer rein kapazitiven Last an das TN-Wechselstromnetz 3 angeschlossen. Dann wird eine Spannung $U_{LN}$ zwischen der Phase L und dem Neutralleiter N gemessen. Weiter wird ein Differenzstrom $I_{LN}$ zwischen der Phase L und dem Neutralleiter N gemessen.

Durch den Vergleich des Phasenverlaufs der Spannung $U_{LN}$ mit dem Phasenverlauf des Differenzstroms $I_{LN}$ lässt sich ein Wert für die Phasenverschiebung der Spannung $U_{LN}$ zu dem Differenzstrom $I_{LN}$ bestimmen. Alternativ könnte auch ein nachgeschalteter Zweig mit einer rein induktiven Last oder einer rein resistiven Last angeschlossen werden. Andere Justagemöglichkeiten, z.B. mit Hilfe eines 2-Kanal Oszilloskops, wären auch denkbar.

In einem zweiten Schritt S2 wird statt dem nachgeschalteten Zweig mit einer rein kapazitiven Last der zu vermessende nachgeschaltete Zweig 2 an das TN-Wechselstromnetz 3 angeschlossen. Weiter wird eine Spannung $U_{LN}$ zwischen der Phase L und dem Neutralleiter N gemessen. Zudem wird ein Differenzstrom $I_{LN}$ zwischen der Phase L und dem Neutralleiter N mittels eines Differenzstromsensors 5 gemessen. Dabei wird sowohl die Spannung $U_{LN}$ als auch der Differenzstrom $I_{LN}$ abtastend gemessen. Demnach erhält man einen digitalisierten Spannungsverlauf und einen digitalisierten Differenzstromverlauf.

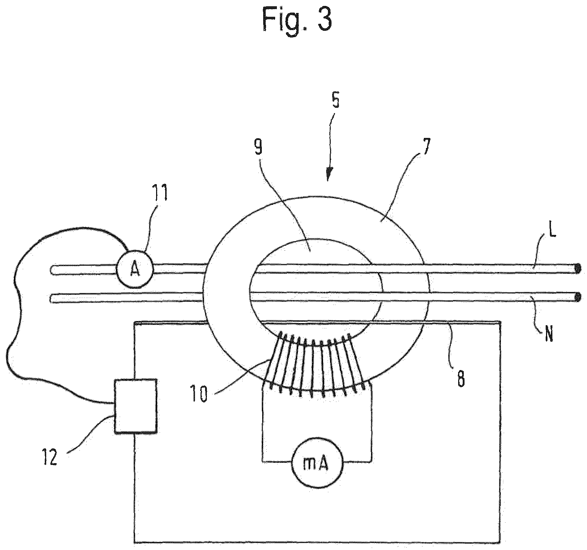

Der Differenzstrom $I_{LN}$ kann beispielsweise mit einem Differenzstromsensors 5, wie er in den Fig. 3 bis 5 beschrieben ist, gemessen werden.

In einem dritten Schritt S3 wird die Phasenverschiebung zwischen dem im zweiten Schritt ermittelten Differenzstrom $I_{LN}$ und der im zweiten Schritt ermittelten Spannung $U_{LN}$ korrigiert. Dies geschieht z.B. indem die Phase des im zweiten Schritt ermittelten Differenzstroms $I_{LN}$ um den im ersten Schritt ermittelten Wert für die Phasenverschiebung korrigiert wird. Diese Korrektur erfolgt vorzugsweise digital.

In einem vierten Schritt S4 werden mehrere einzelne Differenzstromwerte $I_{LN,i}$ und mehrere einzelne Spannungswerte $U_{LN,i}$ bestimmt. Dabei sind die Differenzstromwerte $I_{LN,i}$ zu den Spannungswerten $U_{LN,i}$ bereits, wie zuvor beschrieben, phasenkorrigiert. Insgesamt wird eine Anzahl von jeweils n Werten bestimmt.

In einem fünften Schritt S5 wird die Wirkleistung P bestimmt. Prinzipiell wird die Wirkleistung über folgende Formel berechnet:

$$P = \frac{1}{T} \int_{t_0}^{t_0+T} U_{LN} * I_{LN}\, dt$$

Dabei ist T die Periodendauer eines Netzzyklus. Insbesondere wird mindestens eine viertel Periode als Integrationszeit verwendet. Vorzugsweise wird über einen Netzzyklus oder über mehrere Netzzyklen integriert. Im vorliegenden Fall wird die Wirkleistung P aus den mehreren einzelnen Differenzstromwerten $I_{LN,i}$ und den mehreren einzelnen Spannungswerten $U_{LN,i}$ mittels folgender Formel bestimmt:

$$P = \frac{1}{n} \sum_{i=1}^{n} U_{LN,i} * I_{LN,i}$$

In einem sechsten Schritt S6 wird die Effektivspannung $U_{Eff}$ mittels der Spannungswerte $U_{LN,i}$ über folgende Formel bestimmt:

$$U_{Eff} = \sqrt{\frac{1}{n} \sum_{i=1}^{n} U_{LN,i}^2}$$

In einem siebten Schritt S7 wird der resistive Anteil der Ableitstromimpedanz $R_{iso}$ mittels der Effektivspannung $U_{Eff}$ und der Wirkleistung P über folgende Formel bestimmt:

$$R_{iso} = \frac{U_{Eff}^2}{P}$$

Dabei entspricht der resistive Anteil der Ableitstromimpedanz $R_{iso}$ im Wesentlichen dem Isolationswiderstand des nachgeschalteten Zweigs 2 und ist somit ein Maß für die Qualität der Isolation des nachgeschalteten Zweigs 2.

In einem weiteren Schritt kann das TN-Wechselstromnetz 3 abgeschaltet werden, wenn der resistive Anteil der Ableitstromimpedanz $R_{iso}$ einen vorbestimmten Wert unterschreitet.

Die Korrektur der Phasenverschiebung zwischen dem Differenzstrom $I_{LN}$ und der Spannung $U_{LN}$ kann verbessert werden, indem mittels Interpolation ein Spannungsverlauf aus den einzelnen Spannungsabtastwerten ermittelt wird und indem mittels Interpolation ein Differenzstromverlauf aus den einzelnen Differenzstromabtastwerten ermittelt wird. Die Phasenverschiebung der so ermittelten Verläufe kann besser bestimmt werden.

Das in Fig. 1 dargestellte TN-Wechselstromnetz 3 weist eine Phase L auf. Alternativ kann ein TN-Wechselstromnetz 3 auch zwei oder drei Phasen L aufweisen. In diesem Fall kann der resistive Anteil der Ableitstromimpedanz $R_{iso}$ für jede Phase L separat bestimmt werden.

Fig. 3 zeigt eine schematische Ansicht des in Fig. 1 dargestellten Differenzstromsensors 5. Der Differenzstromsensor 5 weist einen Kern 7 und einen Kompensationsleiter 8 auf. Dabei sind die Phase L, der Neutralleiter N und der Kompensationsleiter 8 durch den Kern 7 hindurchgeführt. Insbesondere können die Phase L, der Neutralleiter N und der Kompensationsleiter 8 jeweils mehrfach um den Kern 7 gewickelt sein. Der Kern 7 kann als geschlossenes, insbesondere kreisförmiges Gebilde mit einer Durchgangsöffnung 9 ausgebildet sein. Mittels einer Messwicklung 10 kann der Differenzstrom $I_{LN}$ erfasst werden.

Mittels des Kompensationsleiters 8 kann ein Fehler des Differenzstromsensors 5 ausgeglichen werden. Der Fehler ergibt sich aufgrund der nicht perfekten Symmetrie des Phase L und des Neutralleiters N in Bezug auf den Kern 7. Mittels eines Stroms durch den Kompensationsleiter 8 kann dieser Asymmetriefehler ausgeglichen werden.

Der Differenzstromsensor 5 kann weiter einen Strommesser 11 und eine Steuereinheit 12 aufweisen. Die von dem Strommesser 11 gemessene Stromstärke liegt insbesondere in einem Bereich von 0 bis 20 A. Die Stromstärke kann aber auch höher als 20 A sein. Mittels des Strommessers 11 wird ein Stromsignal der Phase L gemessen. Der Strommesser 11 ist mit der Steuereinheit 12 verbunden, so dass die Steuereinheit 12 das Stromsignal weiterverarbeiten kann. Die Steuereinheit 12 steuert den Stromfluss durch den Kompensationsleiter 8 zum Ausgleichen des Asymmetriefehlers.

Insbesondere kann der durch den Kompensationsleiter 8 fließende Strom proportional zu dem Strom sein, welcher durch die Phase L fließt.

Alternativ könnte mittels eines Strommessers 11 auch der Strom des Neutralleiters N gemessen werden, um den Asymmetriefehler auszugleichen.

Weiter kann die Kompensation des Asymmetriefehlers alternativ auch digital ausgeführt werden, wie weiter unten beschrieben wird.

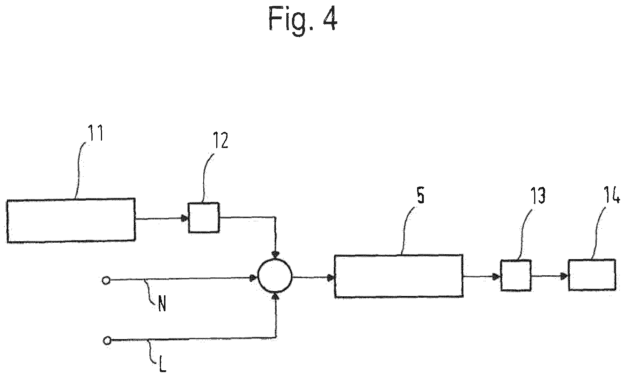

Fig. 4 zeigt ein Blockschaltbild des in Fig. 3 dargestellten Differenzstromsensors 5. Der Strom, welcher mittels des Strommessers 11 gemessen wird, kann über die Steuereinheit 12 und die Kompensationsleitung 8 zusammen mit der Phase L und dem Neutralleiter N in den Differenzstromsensor 5 geführt werden. Der gemessene Differenzstrom $I_{LN}$ kann über eine Verstärkerschaltung 13 und einen Analog-Digital-Umsetzer 14 weitergeleitet werden.

Durch den Asymmetrischen Aufbau des Differenzstromsensors 5 entsteht ein Fehler, welcher linear proportional zum Strom, welcher im Stromkreis fließt, auftritt. Durch die passend verstärkte Rückführung des Stromsignals des Strommessers 11 in den Sensorkreis mittels der Kompensationsleitung 8, lässt sich der lineare Fehler analog kompensieren.

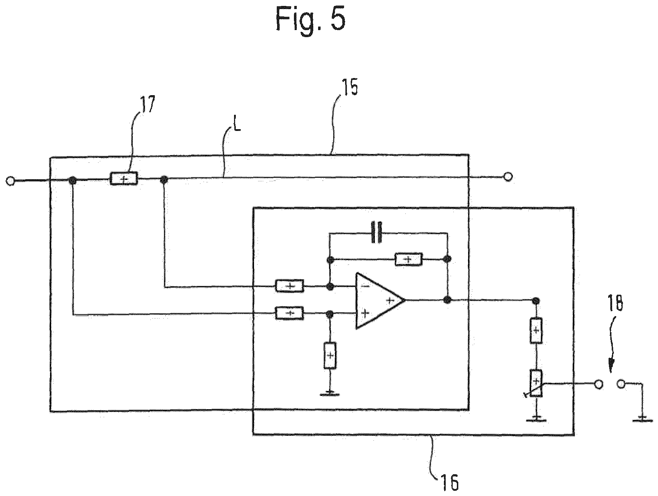

Fig. 5 zeigt einen Schaltplan zur Ansteuerung des Kompensationsleiters 8 des in Fig. 3 dargestellten Differenzstromsensors 5. Dargestellt ist die Phase L, der Schaltplan 15 für den Strommesser 11, der Schaltplan 16 für die Steuereinheit 12, der Shunt 17 für die Strommessung des Strommessers 11 und die Anschlüsse 18 für den Kompensationsleiter 8. Mittels eine Verstärkungsschaltung und einem Spannungsteiler wir das Stromsignal des Strommessers 11 für die Kompensation passend verstärkt. Die Anschlüsse 18 sind mit dem Kompensationsleiter 8 verbunden.

Statt an der Phase L kann der Strom alternativ auch an dem Neutralleiter N gemessen werden, da die Phase L und der Neutralleiter N den Verbraucherstromkreis bilden.

Alternativ kann die Kompensation des Asymmetriefehlers des Differenzstromsensors 5 auch digital implementiert werden. Dazu werden die Messgrößen Strom der Phase L (bzw. Strom des Neutralleiters N) und Differenzstrom $I_{LN}$ erfasst. Mittels des Stroms der Phase L wird dann der Differenzstrom $I_{LN}$ digital korrigiert. Aus der Messgröße Strom der Phase L wird z.B. ein Faktor Kp berechnet. Zu jedem gemessenen Differenzstromwert $I_{LN,i}$ wird dann ein Wert $Kp*I_{LN,i}$ abgezogen.

Bezugszeichenliste:

| 1 | Vorrichtung |
|---|---|
| 2 | Nachgeschalteter Zweig |
| 3 | TN-Wechselstromnetz |
| 4 | Spannungssensor |
| 5 | Differenzstromsensor |
| 6 | Auswerteeinheit |
| 7 | Kern |
| 8 | Kompensationsleiter |
| 9 | Durchgangsöffnung |
| 10 | Messwicklung |
| 11 | Strommesser |
| 12 | Steuereinheit |

13    Verstärkerschaltung
14    Analog-Digital-Umsetzer
15    Schaltplan
16    Schaltplan
17    Shunt
18    Anschlüsse

L     Phase
N     Neutralleiter
PE    Schutzleiter
$R_{iso}$  resistiver Anteil der Ableitstromimpedanz

**Patentansprüche**

1. Verfahren zum Bestimmen des resistiven Anteils der Ableitstromimpedanz ($R_{iso}$) eines nachgeschalteten Zweigs (2) an ein Wechselstromnetz mit einer Phase (L), einem Neutralleiter (N) und einem Schutzleiter (PE), mit den Schritten:

   - Abtastendes Messen eines Differenzstroms $I_{LN}$ zwischen der Phase (L) und dem Neutralleiter (N) mittels eines Differenzstromsensors (5),
   - Abtastendes Messen einer Spannung U zwischen der Phase (L) und dem Neutralleiter (N) oder zwischen der Phase (L) und dem Schutzleiter (PE),
   - Korrigieren einer Phasenverschiebung zwischen dem Differenzstrom $I_{LN}$ und der Spannung U,
   - Bestimmen mehrerer einzelner Differenzstromwerte $I_{LN,i}$ und mehrerer einzelner Spannungswerte U;, wobei die Differenzstromwerte $I_{LN,i}$ zu den Spannungswerten $U_i$ phasenkorrigiert sind,
   - Bestimmen der Wirkleistung P aus den mehreren einzelnen Differenzstromwerten $I_{LN,i}$ und den mehreren einzelnen Spannungswerten $U_i$,
   - Bestimmen der Effektivspannung $U_{Eff}$ mittels der Spannungswerte $U_i$, und
   - Bestimmen des resistiven Anteils der Ableitstromimpedanz ($R_{iso}$) mittels der Effektivspannung $U_{Eff}$ und der Wirkleistung P.

2. Verfahren nach Anspruch 1, wobei das Wechselstromnetz ein TN-Wechselstromnetz (3) ist.

3. Verfahren nach Anspruch 1 oder 2, wobei zum Justieren einer Vorrichtung (1) zum Bestimmen des resistiven Anteils der Ableitstromimpedanz ($R_{iso}$) zuerst ein Wert für das Korrigieren der Phasenverschiebung ermittelt wird, indem an das Wechselstromnetz ein nachgeschalteter Zweig (2) mit einer rein kapazitiven Last, einer rein induktiven Last oder einer rein resistiven Last angeschlossen wird, und dann eine Spannung U und ein Differenzstrom $I_{LN}$ mit diesem nachgeschalteten Zweig (2) ermittelt wird.

4. Verfahren nach einem der vorhergehenden Ansprüche, wobei bei dem abtastenden Messen eines Differenzstroms $I_{LN}$ einzelne Differenzstromabtastwerte gemessen werden, bei dem abtastenden Messen einer Spannung U einzelne Spannungsabtastwerte gemessen werden, ein zeitlicher Differenzstromverlauf aus einer Interpolation der Differenzstromabtastwerte gewonnen wird, und ein zeitlicher Spannungsverlauf aus einer Interpolation der Spannungsabtastwerte gewonnen wird, um die Korrektur der Phasenverschiebung zwischen dem Differenzstrom $I_{LN}$ und der Spannung U zu verbessern.

5. Verfahren nach einem der vorhergehenden Ansprüche, wobei bei dem abtastenden Messen des Differenzstroms $I_{LN}$ der Differenzstromsensor (5) einen Kompensationsleiter (8) aufweist, und wobei mittels des Kompensationsleiters (8) ein Fehler des Differenzstromsensors (5) ausgeglichen wird.

6. Verfahren nach Anspruch 5, wobei der durch den Kompensationsleiter (8) fließende Strom proportional zu dem Strom ist, welcher durch die Phase (L) oder den Neutralleiter (N) fließt.

7. Verfahren nach einem der Ansprüche 1 bis 4, wobei ein Fehler des Differenzstromsensors (5) ausgeglichen wird, indem aus der Messgröße Strom der Phase (L) und/oder aus der Messgröße Strom des Neutralleiters (N) ein Faktor Kp berechnet wird, und wobei zu jedem gemessenen Differenzstromwert $I_{LN,i}$ ein Wert $Kp*I_{LN,i}$ abgezogen wird.

8. Verfahren nach einem der vorhergehenden Ansprüche, wobei das Wechselstromnetz abgeschaltet wird und/oder eine Meldung an ein übergeordnetes System gesendet wird, wenn der resistive Anteil der Ableitstromimpedanz ($R_{iso}$) einen vorbestimmten Wert unterschreitet.

9. Vorrichtung (1) angepasst zum Bestimmen des resistiven Anteils der Ableitstromimpedanz ($R_{iso}$) eines nachgeschalteten Zweigs (2) an ein Wechselstromnetz mit einer Phase (L), einem Neutralleiter (N) und einem Schutzleiter (PE) mittels eines Verfahrens nach einem der Ansprüche 1 bis 8, aufweisend

   einen Spannungssensor (4) angepasst zum abtastenden Messen der Spannung U zwischen der Phase (L) und dem Neutralleiter (N) oder zwischen der Phase (L) und dem Schutzleiter (PE),
   einen Differenzstromsensor (5) angepasst zum abtastenden Messen eines Differenzstroms $I_{LN}$ zwischen der Phase (L) und dem Neutralleiter (N), und

eine Auswerteeinheit (6) angepasst zum Korrigieren einer Phasenverschiebung zwischen dem Differenzstrom $I_{LN}$ und der Spannung U, angepasst zum Bestimmen mehrerer einzelner Differenzstromwerte $I_{LN,i}$ und mehrerer einzelner Spannungswerte $U_i$, wobei die Differenzstromwerte $I_{LN,i}$ zu den Spannungswerten $U_i$ phasenkorrigiert sind, angepasst zum Bestimmen der Wirkleistung P aus den mehreren einzelnen Differenzstromwerten $I_{LN,i}$ und den mehreren einzelnen Spannungswerten $U_i$, angepasst zum Bestimmen der Effektivspannung $U_{Eff}$ mittels der Spannungswerte $U_i$, und angepasst zum Bestimmen des resistiven Anteils der Ableitstromimpedanz ($R_{iso}$) mittels der Effektivspannung $U_{Eff}$ und der Wirkleistung P.

10. Vorrichtung nach Anspruch 9, wobei der Differenzstromsensor (5) einen Kern (7) und einen Kompensationsleiter (8) aufweist und wobei die Phase (L), der Neutralleiter (N) und der Kompensationsleiter (8) durch den Kern (7) hindurchgeführt sind.

11. Verteilerschrank mit zumindest einer Vorrichtung (1) nach einem der Ansprüche 9 oder 10.

12. Verteilerschrank nach Anspruch 11, wobei die zumindest eine Vorrichtung (1) als Reihenklemme ausgebildet ist.

13. Verteilerschrank nach Anspruch 11 oder 12, wobei der Verteilerschrank zumindest eine weitere Vorrichtung (1) aufweist, und Messwerte der zumindest einen Vorrichtung (1) mit der zumindest einen weiteren Vorrichtung (1) ausgetauscht werden.

**Claims**

1. A method for determining the resistive component of the leakage current impedance ($R_{iso}$) of a downstream branch (2) to an alternating current network having a phase (L), a neutral conductor (N) and a protective conductor (PE), comprising the steps of:

- measuring, by scanning, a differential current $I_{LN}$ between the phase (L) and the neutral conductor (N) by means of a differential current sensor (5),
- measuring, by scanning, a voltage U between the phase (L) and the neutral conductor (N) or between the phase (L) and the protective conductor (PE),
- correcting a phase shift between the differential current $I_{LN}$ and the voltage U,
- determining several individual differential current values $I_{LN,i}$ and several individual voltage

values $U_i$, wherein the differential current values $I_{LN,i}$ are phase-corrected with respect to the voltage values $U_i$,
- determining the effective power P from the several individual differential current values $I_{LN,i}$ and the several individual voltage values $U_i$,
- determining the effective voltage $U_{Eff}$ by means of the voltage values $U_i$, and
- determining the resistive component of the leakage current impedance ($R_{iso}$) by means of the effective voltage $U_{Eff}$ and the effective power P.

2. The method according to claim 1, wherein the alternating current network is a TN alternating current network (3).

3. The method according to claim 1 or 2, wherein for adjusting a device (1) for determining the resistive component of the leakage current impedance ($R_{iso}$), first a value for correcting the phase shift is determined by connecting a downstream branch (2) having a purely capacitive load, a purely inductive load or a purely resistive load to the alternating current network, and then a voltage U and a differential current $I_{LN}$ are determined with this downstream branch (2).

4. The method according to any one of the preceding claims, wherein individual differential current scanning values are measured when measuring, by scanning, a differential current $I_{LN}$, individual voltage scanning values are measured when measuring, by scanning, a voltage U, a temporal differential current curve is obtained from an interpolation of the differential current scanning values, and a temporal voltage curve is obtained from an interpolation of the voltage scanning values in order to improve the correction of the phase shift between the differential current $I_{LN}$ and the voltage U.

5. The method according to any one of the preceding claims, wherein the differential current sensor (5) includes a compensation conductor (8) when measuring, by scanning, the differential current $I_{LN}$, und wherein an error of the differential current sensor (5) is compensated by means of the compensation conductor (8).

6. The method according to claim 5, wherein the current flowing through the compensation conductor (8) is proportional to the current flowing through the phase (L) or the neutral conductor (N).

7. The method according to any one of the claims 1 to 4, wherein an error of the differential current sensor (5) is compensated by calculating a factor Kp from the measured variable current of the phase (L) and/or from the measured variable current of the neutral conductor (N), and wherein a value $Kp*I_{LN,i}$ is deducted for each measured differential current value $I_{LN,i}$.

8.  The method according to any one of the preceding claims, wherein the alternating current network is switched off and/or a message is sent to a higher-level system if the resistive component of the leakage current impedance ($R_{iso}$) falls below a predetermined value.

9.  A device (1) adapted for determining the resistive component of the leakage current impedance ($R_{iso}$) of a downstream branch (2) to an alternating current network having a phase (L), a neutral conductor (N) and a protective conductor (PE) by means of a method according to any one of the claims 1 to 8, comprising

    a voltage sensor (4) adapted for measuring, by scanning, a voltage U between the phase (L) and the neutral conductor (N) or between the phase (L) and the protective conductor (PE),
    a differential current sensor (5) adapted for measuring, by scanning, a differential current $I_{LN}$ between the phase (L) and the neutral conductor (N), and
    an evaluation unit (6) adapted for correcting a phase shift between the differential current $I_{LN}$ and the voltage U, adapted for determining several individual differential current values $I_{LN,i}$ and several individual voltage values $U_i$, wherein the differential current values $I_{LN,i}$ are phase-corrected with respect to the voltage values $U_i$, adapted for determining the effective power P from the several individual differential current values $I_{LN,i}$ and the several individual voltage values $U_i$, adapted for determining the effective voltage $U_{Eff}$ by means of the voltage values $U_i$, and adapted for determining the resistive component of the leakage current impedance ($R_{iso}$) by means of the effective voltage $U_{Eff}$ and the effective power P.

10. The device according to claim 9, wherein the differential current sensor (5) includes a core (7) and a compensation conductor (8), and wherein the phase (L), the neutral conductor (N), and the compensation conductor (8) are passed through the core (7).

11. A distribution cabinet, comprising at least one device (1) according to any one of the claims 9 or 10.

12. The distribution cabinet according to claim 11, wherein the device (1) is designed as a terminal block.

13. The distribution cabinet according to claim 11 or 12, wherein the distribution cabinet includes at least one further device (1), and measured values of the at least one device (1) are exchanged with the at least one further device (1).

**Revendications**

1.  Procédé pour déterminer la partie résistive de l'impédance de courant de fuite ($R_{iso}$) d'une branche aval (2) sur un réseau de courant alternatif comportant une phase (L), un conducteur neutre (N) et un conducteur de protection (PE), comprenant les étapes consistant à :

    - mesurer par échantillonnage un courant différentiel $I_{LN}$ entre la phase (L) et le conducteur neutre (N) au moyen d'un capteur de courant différentiel (5),
    - mesurer par échantillonnage une tension U entre la phase (L) et le conducteur neutre (N) ou entre la phase (L) et le conducteur de protection (PE),
    - corriger un déphasage entre le courant différentiel $I_{LN}$ et la tension U,
    - déterminer plusieurs valeurs de courant différentiel individuelles $I_{LN,i}$ et plusieurs valeurs de tension individuelles $U_i$, les valeurs de courant différentiel $I_{LN,i}$ étant corrigées en phase par rapport aux valeurs de tension $U_i$,
    - déterminer la puissance active P à partir des plusieurs valeurs de courant différentiel individuelles $I_{LN,i}$ et des plusieurs valeurs de tension individuelles $U_i$,
    - déterminer la tension efficace $U_{Eff}$ au moyen des valeurs de tension $U_i$, et
    - déterminer la partie résistive de l'impédance de courant de fuite ($R_{iso}$) au moyen de la tension efficace $U_{Eff}$ et de la puissance active P.

2.  Procédé selon la revendication 1, dans lequel le réseau de courant alternatif est un réseau de courant alternatif TN (3).

3.  Procédé selon la revendication 1 ou 2, dans lequel, pour ajuster un dispositif (1) pour déterminer la composante résistive de l'impédance de courant de fuite (Riso), on détermine d'abord une valeur pour corriger le déphasage en connectant au réseau de courant alternatif une branche aval (2) comportant une charge purement capacitive, une charge purement inductive ou une charge purement résistive, puis on détermine une tension U et un courant différentiel $I_{LN}$ avec cette branche aval (2).

4.  Procédé selon l'une des revendications précédentes, dans lequel, lors de la mesure par échantillonnage d'un courant différentiel $I_{LN}$, on mesure des échantillons individuels de courant différentiel, lors de la mesure par échantillonnage d'une tension U, on mesure des échantillons individuels de tension, on acquiert une variation temporelle du courant différentiel à partir d'une interpolation des échantillons de courant différentiel et on acquiert une variation temporelle de la tension à partir d'une interpolation des échantillons de tension afin d'améliorer la correction du déphasage entre le courant différentiel $I_{LN}$ et la tension U.

5. Procédé selon l'une des revendications précédentes, dans lequel, lors de la mesure par échantillonnage du courant différentiel $I_{LN}$, le capteur de courant différentiel (5) présente un conducteur de compensation (8), et dans lequel une erreur du capteur de courant différentiel (5) est compensée au moyen du conducteur de compensation (8).

6. Procédé selon la revendication 5, dans lequel le courant circulant dans le conducteur de compensation (8) est proportionnel au courant qui circule dans la phase (L) ou le conducteur neutre (N).

7. Procédé selon l'une des revendications 1 à 4, dans lequel une erreur du capteur de courant différentiel (5) est compensée en calculant un facteur Kp à partir de la grandeur de mesure courant de la phase (L) et/ou de la grandeur de mesure courant du conducteur neutre (N), et dans lequel une valeur $Kp*I_{LN,i}$ est déduite de chaque valeur de courant différentiel mesurée $I_{LN,i}$.

8. Procédé selon l'une des revendications précédentes, dans lequel le réseau de courant alternatif est déconnecté et/ou un message est envoyé à un système supérieur lorsque la partie résistive de l'impédance de courant de fuite ($R_{iso}$) est inférieure à une valeur prédéterminée.

9. Dispositif (1) adapté à déterminer la composante résistive de l'impédance de courant de fuite ($R_{iso}$) d'une branche aval (2) sur un réseau de courant alternatif comportant une phase (L), un conducteur neutre (N) et un conducteur de protection (PE), au moyen d'un procédé selon l'une des revendications 1 à 8, présentant :

un capteur de tension (4) adapté à mesurer par échantillonnage la tension U entre la phase (L) et le conducteur neutre (N) ou entre la phase (L) et le conducteur de protection (PE), un capteur de courant différentiel (5) adapté à mesurer par échantillonnage un courant différentiel $I_{LN}$ entre la phase (L) et le conducteur neutre (N), et une unité d'évaluation (6) adaptée à corriger un déphasage entre le courant différentiel $I_{LN}$ et la tension U, adaptée à déterminer plusieurs valeurs de courant différentiel individuelles $I_{LN,i}$ et plusieurs valeurs de tension individuelles $U_i$, les valeurs de courant différentiel $I_{LN,i}$ étant corrigées en phase par rapport aux valeurs de tension $U_i$, adaptée à déterminer la puissance active P à partir des plusieurs valeurs de courant différentiel individuelles $I_{LN,i}$ et des plusieurs valeurs de tension individuelles $U_i$, adaptée à déterminer la tension efficace $U_{Eff}$ au moyen des valeurs de tension $U_i$, et adaptée à déterminer la partie résistive de l'impédance de courant de fuite ($R_{iso}$) au moyen de la tension efficace $U_{Eff}$ et de la puissance active P.

10. Dispositif selon la revendication 9, dans lequel le capteur de courant différentiel (5) présente un noyau (7) et un conducteur de compensation (8), et dans lequel la phase (L), le conducteur neutre (N) et le conducteur de compensation (8) passent à travers le noyau (7).

11. Armoire de distribution comprenant au moins un dispositif (1) selon l'une des revendications 9 ou 10.

12. Armoire de distribution selon la revendication 11, dans laquelle ledit au moins un dispositif (1) est réalisé sous la forme d'un bloc de jonction.

13. Armoire de distribution selon la revendication 11 ou 12, dans laquelle l'armoire de distribution présente au moins un autre dispositif (1), et des valeurs de mesure dudit au moins un dispositif (1) sont échangées avec ledit au moins un autre dispositif (1).

# Fig. 1

# Fig. 2

# Fig. 3

Fig. 4

# Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19826410 A1
- US 6922643 B2
- DE 10355086 A1
- EP 3136115 A1
- EP 2571128 A2
- US 20030112015 A1
- DE 102015218911 A1